# DEMANDE DE BREVET EUROPEEN

(11) **EP 2 447 985 A1**
(43) Date de publication de la demande: **02.05.2012**
(21) Numéro de dépôt: 10306192.5
(22) Date de dépôt: 29.10.2010
(51) Int. Cl.: H01L 21/48, H01L 23/538

(54) **Procédé pour réaliser des lignes d'interconnexion ou de redirection d'au moins un composant à circuit intégré**

(71) Demandeur: Gemalto SA, 92190 Meudon (FR)
(72) Inventeur: Dubois, Béatrice, 13100 Aix en Provence (FR); Cauchois, Romain, 13100 Aix en Provence (FR)

(57) **Abrégé**

L'invention concerne un procédé pour réaliser des lignes d'interconnexion (3) d'un composant à circuit intégré 1, ledit procédé comportant une étape de :
- fixation ou d'enrobage partiel d'au moins une puce (2) sur un substrat (4), de manière à offrir une face active (8) de la puce orientée vers l'extérieur, ledit composant à circuit intégré présentant des plots de contact électrique (5a, 5b, 15a, 15b)disposés sur la face active de la puce,
- réalisation d'une couche isolante (6, 16) sur la surface active sans recouvrir les plots de contact,
- réalisation de pistes conductrices de redirection / interconnexion (3) s'étendant au moins en partie sur ladite couche isolante à partir des plots de contact (5) jusqu'à des points externes (p) situés sur ou au-dessus du substrat ;

Le procédé se distingue en ce que la couche isolante (16, 26) comporte au moins une portion constituant un pont s'étendant d'un bord (20, 40) de la surface active de la puce jusque sur la surface (S) du substrat.

L'invention concerne aussi le composant correspondant.

## Description

L'invention concerne un procédé pour réaliser des lignes d'interconnexion ou de redirection d'un composant à circuit intégré et le composant ainsi obtenu.

Les composants visés par l'invention peuvent être conditionnés sous différentes formes, par exemple en forme de boitiers électroniques, modules pour cartes à puce, petits objets électroniques notamment au format carte à mémoire de masse, Micro-SIM (*Subscriber Identity Module* en langue anglaise) ou Plug-in SIM, Mini UICC (*Universal Integrated Circuit Card* en langue anglaise), micro SIM au format 3FF ou sous forme de module de communication de type M2M (Machine to Machine). Ils peuvent être également conditionnés sous forme de composants à monter en surface (CMS ou SMD).

Ces composants électroniques portables trouvent notamment leurs applications dans la santé, la banque, les télécommunications ou encore le contrôle d'identité et sont de préférence sécurisés.

Dans l'art antérieur, la demande de brevet EP 0901688-A1 décrit un procédé pour réaliser des redirections de contacts électriques d'un composant électronique à circuit intégré par un dépôt de matière conductrice liquide sur la face active d'une puce de circuit intégré. Au préalable, une couche d'isolant est réalisée sur toute la surface active à l'exception des plots de contact ; Les pistes conductrices de redirection / interconnexion sont confinées à l'intérieur de la surface active de la puce. Les pistes en matière conductrice sont orientées vers l'extérieur de la puce à partir des plots.

Ce document décrit comme art antérieur des puces enfoncées dans un corps de carte au format de carte ISO 7816 avec la face active des puces orientées vers l'extérieur et affleurant à la surface; Des pistes et des plages de contacts sont réalisées par dépôt de matière conductrice sur la surface du corps de carte à puce et en partie sur la surface active des puces ; Elles s'étendent à partir des plots vers la périphérie des puces puis vers les plages de contact situées sur la surface du corps de carte.

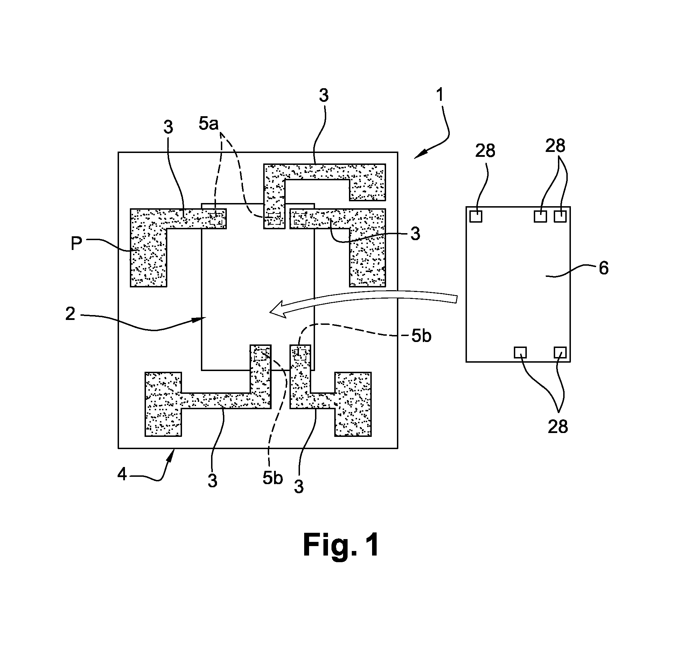

Les inventeurs proposent d'améliorer un procédé illustré à la figure 1 et en cours de développement. Ce procédé comprend les étapes ci-après :
- D'enrobage partiel ou fixation d'au moins une puce sur un substrat de conditionnement, en offrant une face active de la puce orientée vers l'extérieur avec des plots de contact électrique sur sa face active ;
- De réalisation d'une couche d'isolant sur toute ou partie de la surface active à l'exception des plots de contact nécessaire à l'application. De façon avantageuse certain plots, non nécessaire, pourront être masqués par le dépôt de la couche isolante ;
- Et de réalisation de pistes conductrices de redirection / interconnexion s'étendant des plots de contact jusqu'à des points externes situés sur ou au-dessus du substrat, ou interconnectant des composants entre eux. Au cours de la mise en oeuvre, les pistes de matière conductrice sont orientées vers l'extérieur de la puce à partir des plots.

Ces dépôts de matière conductrice peuvent être de mauvaise qualité (adhésion ou définition) ou induire des courts-circuits si les matériaux du substrat sur lesquelles elles sont déposées, sont différents tout au long du parcours du dépôt et / ou s'il y a des différences de niveau du substrat. En effet, une matière conductrice telle qu'une encre déposée sous forme liquide, a tendance à circuler le long du bord de la puce à l'interface puce / substrat avec le risque d'un court-circuit entre deux lignes ou pistes qui seraient trop contiguës.

Un court-circuit peut se produire au niveau de la tranche de la puce qui n'est pas isolée. L'encre conductrice peut en effet fluer par capillarité entre la tranche et l'enrobage. En outre, des marches ou des épaulements à 90 ° peuvent être le siège d'une absence de matériau conducteur car toute l'encre affectée à la marche se concentre vers le bas de celle-ci par gravité et peuvent provoquer une discontinuité électrique. Les niveaux de marche peuvent être différents d'un composant à l'autre même en étant de même nature.

La technique actuelle a l'inconvénient d'exiger une précision importante pour empêcher un recouvrement des plots par de la matière isolante. Les vitesses de dépôts peuvent en être ralenties. Dans certains cas, le motif de matière isolante chevauche les plots suite à un décalage par rapport à la surface active de la puce.

L'invention permet de répondre aux inconvénients ci-dessus et d'accroitre les vitesses de dépôts.

Plus particulièrement, l'invention propose de minimiser les exigences de précision pendant l'étape d'isolation de composants actifs et passifs disposés sur la face supérieure active d'un substrat avant de subir un dépôt direct de lignes conductrices de redistribution (RDL) entre les plots ou des interconnexions. De préférence, l'invention vise à s'affranchir de la topographie de surface, de l'état de surface et/ou nature physique ou chimique du matériau de surface.

Dans son principe, l'invention propose de recourir à une couche d'isolant de motif simplifiée par rapport à l'art antérieur pour permettre les interconnexions de puce; La couche isolante est disposée à cheval sur au moins un bord de la puce et le substrat de manière à les chevaucher.

La couche d'isolant peut s'étendre sur la puce en chevauchant deux bords de la puce de circuits intégrés sans recouvrir les plots d'interconnexion ; Elle peut être déposée à l'aide de techniques d'écriture directe - tels que par exemple, l'impression à jet d'encre, sérigraphie ou pulvérisation d'un revêtement. Cette couche sert à la fois d'isolant sur la surface active de la puce et de pont entre le bord du circuit intégré et le substrat de manière notamment à réduire le dénivelé de la marche ou les infractuosités d'interface entre divers matériaux..

Contrairement à l'art antérieur, il n'est pas nécessaire de connaître l'espacement entre des plots situés d'un même côté d'une puce pour déposer l'isolant sans recouvrir les plots ni l'espacement plots bord immédiat de la puce.

A cette fin, l'invention a pour objet un procédé conforme à la revendication 1 et un composant conforme à la revendication 5.

Le procédé est notamment applicable sur des dispositifs tels que puces de circuits intégrés IC, assemblage de plusieurs puces de circuits intégrés, des enrobages 2D et 3D, certains systèmes micro électromécaniques (MEMS), intercalaires passifs.

Des caractéristiques supplémentaires font l'objet de revendications conformes aux revendications dépendantes.

D'autres caractéristiques et avantages apparaîtront plus clairement à la lecture de la description qui suit et à l'examen des figures parmi lesquelles :
- La figure 1 illustre un procédé actuel développé par les inventeurs et donné pour l'intelligence du problème résolu ; elle représente un composant en vue de dessus;
- La figure 2 illustre en vue de dessus, un composant à puce de circuit intégré obtenu selon un premier mode de mise en oeuvre du procédé conforme à l'invention ;
- La figure 3 illustre en vue de dessus, un composant à plusieurs puces obtenu selon un second mode de mise en oeuvre du procédé conforme à l'invention ;
- La figure 4 illustre une vue partielle en coupe A-A de la figure 3.

Dans les figures, les références communes entre figures désignent les mêmes éléments.

Le composant illustré à la figure 1 a servi comme point de départ de l'invention ; Il peut être obtenu via les étapes suivantes :
- dépôt d'un ensemble d'une ou plusieurs puces, face active vers le bas, sur un premier support ;
- moulage d'une résine pour enrober l'ensemble sur son support, par exemple un ruban adhésif ou non ;
- enlèvement du support et éventuellement retournement pour que la puce ait sa face active exposée ;
- application d'une matière isolante sur toute la surface de la puce 2 à l'exception des plots de contact 5a, 5b ;
- application de matière conductrice ou des pistes sur l'ensemble 3, pour réaliser une plage de contact p reliant un plot de contact 5a de la puce au monde extérieur. Les pistes s'étendent vers l'extérieur de la puce à partir des plots ;
- découpe éventuelle du substrat pour isoler le composant.

Alternativement, l'enrobage peut être facultatif notamment dans le cas où la puce est très fine, par exemple 10 à 50 µm; l'ensemble peut être déposé directement sur un substrat via leur face arrière. Le substrat peut être du Kapton ; le dépôt conducteur peut être réalisé en 3D notamment en sérigraphie).

Alternativement encore, le composant peut être enfoncé dans le substrat comme dans l'art antérieur cité précédemment en laissant sa face active accessible et débouchant à la surface du substrat ou affleurant à sa surface. Le composant ainsi obtenu présente les inconvénients mentionnés précédemment et résolus comme ci-après.

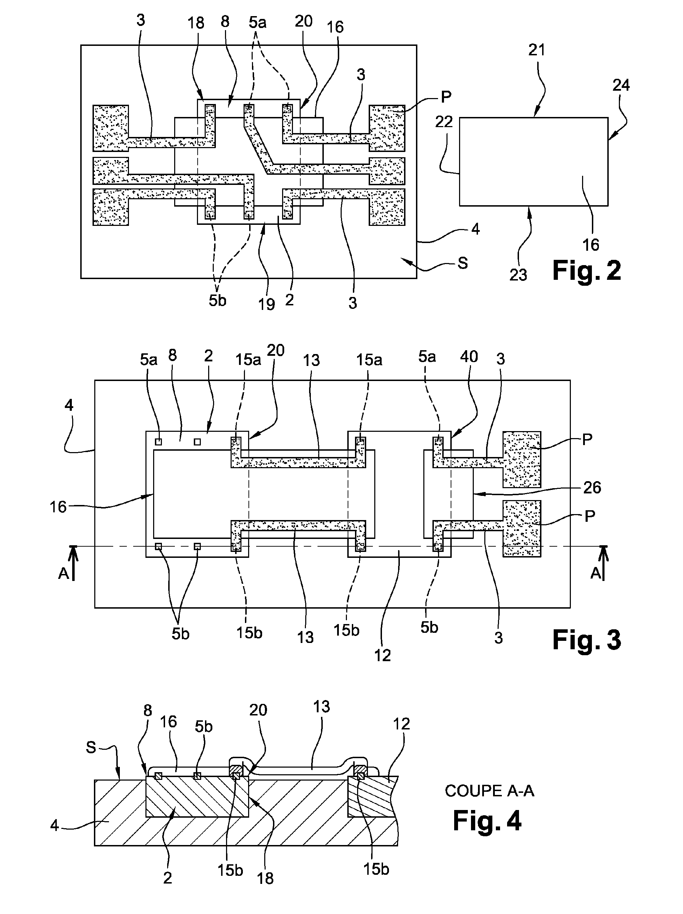

A la figure 2, sont illustrées des lignes d'interconnexion réalisées sur un composant à puce de circuit intégré 1 selon un premier mode de mise en oeuvre de l'invention.

Le composant ainsi fourni comporte des plots à interconnecter ou à rediriger ; Il a pu être obtenu en partie comme précédemment notamment par fixation ou enrobage partiel d'au moins une puce 2 sur un substrat 4. Le report ou enrobage est effectué de manière à offrir une face active 8 de la puce orientée vers l'extérieur ; Le composant à circuit intégré présente des plots de contact électrique 5a, 5b disposés sur la face active de la puce ;

Le procédé selon l'invention, comprend également la réalisation d'une couche isolante 6, 16 sur la surface active sans recouvrir les plots de contact ; Cependant à la différence de la figure précédente et selon un mode préféré de mise en oeuvre, la couche isolante 16, 26 comporte au moins une portion constituant un pont s'étendant d'un bord 20 de la surface active de la puce jusque sur la surface 4 du substrat. De préférence, la couche s'étend au moins en partie sur la surface active de la puce et au moins en partie sur la surface du substrat.

Il peut y avoir plusieurs couches 16 isolantes par puce suivant la structure de celle ci

Les pistes conductrices de redirection / interconnexion 3 s'étendant au moins en partie sur ladite couche isolante à partir des plots de contact 5 jusqu'à des points externes p situés sur ou au-dessus du substrat.

Dans l'exemple, la couche s'étend sur une partie médiane de la puce, sur deux côtés opposés de la puce et déborde en partie de part et d'autre de la puce sur la surface S du substrat 4. Les pistes s'étendent jusqu'à des point p constituées par des plages de contact reliant chaque plot. Avantageusement, les plages sont formées par le même procédé que celui utilisé pour les pistes.

De préférence, la puce électronique 2 est du type présentant deux rangées de plots de contact électrique 5a, 5b disposées respectivement à proximité de bords opposés 18 et 19 de la face active 8 de la puce ; La couche isolante 16, 26 est de préférence réalisée sous forme d'une bande ou rectangle 16, 26 s'étendant entre les deux rangées de plots. Les cotés longitudinaux 21, 22 de la bande sont disposés à distance des rangées de plots 5a, 5b. Les côtés 22, 24 de la couche s'étendent sur les surfaces du substrat.

Cette couche 16 diffère notamment de la couche 6 de la figure 1 par l'absence d'ouverture 28 et par le fait qu'elle est déposée à distance des plots, qu'elle a une dimension en largeur moindre que celle de la surface de la puce et par le fait qu'elle chevauche à la fois au moins un bord de la puce et un bord du substrat adjacent au bord de la puce.

Ainsi, il est aisé de former, par exemple par jet de matière ou sérigraphie, la couche isolante sur la puce sans risquer de recouvrir les plots. On évite aussi un procédé qui consisterait à recouvrir toute la surface de la puce, plot y compris et de les découvrir par la suite notamment par pulse laser. En outre, il n'y a pas besoin de connaître exactement l'espacement des plots entre eux pour positionner la couche isolante.

Conformément à une caractéristique, les pistes conductrices 3, 13 s'étendent des plots 5a, 5b, 15a, 15b vers l'intérieur de la surface active pour être portées par ledit pont de couche isolante 16, 26 jusqu'aux points externes p. Cette caractéristique intervient notamment lorsque les plots sont répartis en périphérie de la puce.

Ainsi, les pistes conductrices raccordant les plots ne passent pas directement au dessus des bords de la puce au risque de créer des courts-circuits (soit entre des plots très proches), soit sur la tranche de la puce par migration de la matière conductrice. Le court-circuit sur la tranche peut se produire par capillarité à l'interface formée par la tranche de la puce 18 et une paroi adjacente du substrat.

Dans cette application, le substrat considéré pourrait être de type organique ou non organique, et peut donc être étendu aux substrats souples. Pour des applications notamment d'électronique flexible avec des substrats minces ou non, le composant peut être amincit.

A la figure 3, le composant comprend deux puces 2, 12 enrobées en partie dans le substrat et distantes entre elles. On réalise une interconnexion 13 respectivement des deux plots 15a, 15b de la puce 2 respectivement avec les plots 15a, 15b de la puce 12 par des pistes ou cordons de matière conductrice 13. On réalise aussi des plages de contact sur la puce 12 sensiblement comme à la figure 2.

Au préalable, on a déposé une couche isolante 16 sous forme de bande qui s'étend entre les deux rangées de plots et qui rejoint les deux puces. La couche 16 forme un pont qui relie les deux puces en s'appuyant sur le substrat dans la zone située entre les puces. Cette bande, ou plusieurs bandes disposées entre les deux composants peuvent être grossièrement structurées et délimités aux zones nécessaires au passage des lignes conductrices.

La bande ici ne couvre que les deux bords rapprochés des deux puces. Des alternatives existent où la couche isolante peut être constituée de plusieurs portions peut être réalisée en plusieurs segments. Certains plots de contacts peuvent être masqués si non utilisés.

Une autre bande 26 est disposée sur un bord de la puce 12 en chevauchant ce bord et en débordant en partie sur la surface active de la puce 12 et sur la surface du substrat. Ce pont 26 sert à supporter des pistes de redirection 3 à l'image de la figure 2 jusqu'à des points P formant des plages de contact.

A la figure 4, correspondant à la coupe A-A, la puce 2 est plus épaisse que la puce 12 et que la surface S de leur enrobage se situe légèrement en dessous de la surface active des puces. Dans ce cas, cette configuration présente, une marche au niveau des bords de chaque puce que l'invention permet de compenser ou d'atténuer autorisant un dépôt convenable et fiable de lignes conductrices.

Les surfaces S du composant et des puces 8 peuvent subir un dépôt supplémentaire d'une couche de finition ou un ajout d'isolant des pistes à l'exception d'au moins une partie des plages de contact destinée à communiquer avec l'extérieur.

L'invention pourrait également être utilisée avec une puce très mince pour lisser la marche. Avec cette solution, la marche visible sur la figure 4, n'est plus de 90 degrés mais est atténuée selon l'isolant utilisé. Une pente réduite entre la couche d'isolation et le substrat est obtenue in-fine après durcissement (polymérisation ou autre) de l'encre conductrice. Cela limite les risques de coulage de l'encre conductrice le long du bord et discontinuité de ligne conductrice au niveau de la marche. L'étape de polymérisation peut être obtenue soit par traitement thermique ou ultraviolet (direct ou indirect) ou autre. Cette couche isolante peut être constituée de matériaux organiques ou minéraux.

Selon un mode de réalisation simplifié, l'invention pourrait consister à déposer un revêtement isolant juste autour des bords des puces pour réduire le dénivelé correspondant au bord de la puce et/ou couche isolante, ou partiellement sur le pourtour.

Selon un autre mode de réalisation (non représenté), la puce présente une rangée de plots de contact électrique disposée sensiblement au centre de la face active de la puce ; la couche isolante s'étend sur la face active à proximité et en dehors des plots et déborde sur au moins un côté de la puce jusque sur la surface (S) du substrat. Par exemple, la couche comprend deux bandes rectangulaires déposées de part et d'autre des plots qui seraient disposés sensiblement au centre. Chaque bande peut alors s'étendre sur un, deux ou trois côté de la puce. Les pistes de redirections s'étendent des plots en direction d'une bande, puis passent au dessus d'un bord de puce en étant supportés par une couche isolante, puis s'étendent encore sur le substrat en étant toujours sur la couche et en s'éloignant des plots.

Un autre avantage de l'invention provient d'une amélioration de l'adhérence entre la couche d'isolant et une encre conductrice par traitement plasma de la couche isolante ou par choix avantageux des interactions chimiques entre la surface de l'isolant et l'encre conductrice. Ainsi l'adhésion des couches substrats, isolant, encre peut être globalement amélioré et stabilisée par rapport à des couches conductrices directement déposées sur le substrat. La nature chimique de l'isolant peut être formulée telle que sa compatibilité soit la plus large possible dans la connaissance de la nature chimique des substrats possible ainsi que des encres conductrices, semi-conductrices. Les encres semi-conductrices et conductrices ne peuvent/doivent pas être modifiées dans leur nature chimique car cela nuirait aux caractéristiques électriques recherchées. Ainsi, il est inutile de recourir à de couches de passivation de l'art antérieur développées à cet effet comme du Si3N4, qui de toute façon ne serait pas déposable en l'état, car il nécessite des traitements dans des bâtis à trop hautes températures. En outre, quelle que soit la passivation du composant, le comportement de l'encre avec l'isolant est toujours identique.

Dans le cas de composant de type UHF, UWB, l'isolant aura une permittivité et une épaisseur telle que les signaux électromagnétiques et interférences électromagnétiques entre le routage et le composant soient réduits.

Ainsi grâce à l'invention et en association avec une technique de dépôt de lignes conductrices de redistribution avec une exigence de précision moindre applicable notamment à l'industrie de la carte à puce, il est possible de créer des motifs d'interconnexion multicouches sur des surfaces actives de puce de circuit intégré. Il est ainsi possible de remplacer des étapes de l'art antérieur propres à la fabrication de semi-conducteur (front-end) ou dans des technologie de type 'galette de semi-conducteur reconstitué' ou puce noyée où une photolithographie de la couche organique isolante, extrêmement précise est nécessaire pour la mise à nu des plots/pads de contact de la puce, pour l'interconnexion ou redistribution des plots de puce de circuits intégrés.

D'autres avantages de l'invention sont présentés ci-après.

L'invention peut être également appliquée sur les différents types de substrats et offre une solution à un risque de discontinuité ou de rupture des lignes de redistribution causées par des décalages de niveaux entre la puce et le substrat, en particulier dans les puces utilisées sur substrat polymère.

L'invention réduit également des risques de mauvais alignement de la puce avec des motifs spécialement conçus avec des ouvertures. L'invention est également indépendante du facteur de forme des puces et est compatible avec davantage de procédés de croissance électrolytique ou non électrolytique.

L'invention permet également d'éviter toute contamination ou chevauchement de l'isolant avec des plots du fait de mauvais alignement relatif des puces par rapport au dépôt de l'isolant. La solution est donc particulièrement bien recommandée lorsque le composant présente une topographie élevée ou accidentée ou hétérogène due par exemple à un conditionnement de puce(s) multiples. En outre, cette solution permet plus de souplesse dans le choix de la technique de dépôt de matière (impression à jet d'encre, aérosol, sérigraphie, revêtement par pulvérisation et l'impression, etc.).

L'invention a également pour avantage d'éviter des fissures au niveau de l'interface en surface puce / substrat. Cette interface peut être le siège de dilation mécanique entre le substrat et la puce et peut être source de tension mécanique au niveau des pistes conductrices provoquant une fissuration et une rupture conductrice.

Le cas échéant, les pistes conductrices et/ou la couche isolante comprennent un composant/constituant ou base élastique ou élastomère apte à apporter de l'élasticité. Dans une certaine mesure les matériaux déposés isolant et conducteur peuvent assumer une élasticité sur un substrat flexible par exemple.

A titre d'exemple, le matériau du substrat 4 est une résine époxy ; Toutefois, d'autres matériaux tels que PC, PET, PEN, PI, PVC, FR4, SiNx, Si, Si02, LCP) peuvent convenir. La couche isolante dans l'exemple est une résine acrylate photosensible déposé par jet d'encre, jet de matière, ou pulvérisation. La surface active de la puce de semi-conducteur est en oxyde de silicium SI02, nitrure de silicium Si3N4 ou polyimide. Les plots sont en aluminium, en or ou en cuivre recouvert éventuellement d'une excroissance en Au ou Ni/Au. La matière conductrice utilisée pour les pistes et les plages de contact est une encre à base de particules d'argent de taille micrométrique ou nanométrique. Toutefois on peut utiliser des encres à base d'aluminium, de cuivre, d'étain, ou d'or.

## Revendications

1. Procédé pour réaliser des lignes d'interconnexion (3) d'un composant à circuit intégré 1, ledit procédé comportant une étape de :
- fixation ou d'enrobage partiel d'au moins une puce (2) sur un substrat (4), de manière à offrir une face active (8) de la puce orientée vers l'extérieur, ledit composant à circuit intégré présentant des plots de contact électrique (5a, 5b, 15a, 15b) disposés sur la face active de la puce,
- réalisation d'une couche isolante (6, 16) sur la surface active sans recouvrir les plots de contact ou au moins ceux utiles à l'application,
- réalisation de pistes conductrices de redirection ou d'interconnexion (3) s'étendant au moins en partie sur ladite couche isolante à partir des plots de contact (5a, 5b, 15a, 15b) jusqu'à des points externes (p) situés sur ou au-dessus du substrat,
**caractérisé en ce que** la couche isolante (16, 26) comporte au moins une portion constituant un pont s'étendant d'un bord (20, 40) de la surface active de la puce jusque sur la surface (S) du substrat.

2. Procédé selon la revendication précédente, **caractérisé en ce que** ladite puce (2) présente deux rangées de plots de contact électrique (5a, 5b) disposées sensiblement à proximité de bords opposés (18, 19) de la face active (8) de la puce et **en ce que** ladite couche isolante (16, 26) est réalisée sous forme d'une bande ou de plusieurs segments s'étendant entre les deux rangées de plots.

3. Procédé selon la revendication précédente, **caractérisé en ce que** les pistes conductrices (3, 13) s'étendent des plots (5a, 5b, 15a, 15b) vers l'intérieur de la surface active pour être portées par ledit pont de couche isolante (16, 26) jusqu'aux points externes (p).

4. Procédé selon la revendication 1, **caractérisé en ce que** ladite puce (2) présente une rangée de plots de contact électrique (5a, 5b) disposée sensiblement au centre de la face active (8) de la puce et **en ce que** ladite couche isolante (16, 26) s'étend sur la face active à proximité et en dehors des plots et déborde sur au moins un côté de la puce jusque sur la surface (S) du substrat.

5. Composant comportant au moins une puce de circuit intégré (2) fixée ou enrobée partiellement sur un substrat (4), de manière à offrir une face active 8 de la puce orientée vers l'extérieur, ledit composant présentant des plots de contact électrique (5a, 5b, 15a, 15b) disposés sur la face active de la puce ; une couche isolante (6, 16) disposée sur la surface active sans recouvrir les plots de contact ; des pistes conductrices de redirection (3) ou d'interconnexion (13) s'étendant au moins en partie sur ladite couche isolante (6, 16) à partir des plots de contact jusqu'à des points externes (p) situés sur ou au-dessus du substrat,
**caractérisé en ce que** la couche isolante (4) comporte au moins une portion constituant un pont s'étendant d'un bord (20, 40) de la surface active (8) de la puce jusqu' à la surface (S) du substrat, ledit pont supportant au moins une piste.
